**Europäisches Patentamt**

(19) **European Patent Office**

**Office européen des brevets**

(11) Veröffentlichungsnummer: **0 035 135**
**B1**

# (12) EUROPÄISCHE PATENTSCHRIFT

(45) Veröffentlichungstag der Patentschrift:
**17.09.86**

(21) Anmeldenummer: **81100881.2**

(22) Anmeldetag: **07.02.81**

(51) Int. Cl.⁴: **H 01 L 25/10**, H 01 L 23/32, H 01 L 23/40

(54) Halbleiterbaueinheit mit wenigstens zwei Halbleiterbauelementen.

(30) Priorität: **13.02.80 DE 3005313**

(43) Veröffentlichungstag der Anmeldung:
**09.09.81 Patentblatt 81/36**

(45) Bekanntmachung des Hinweises auf die Patenterteilung:
**17.09.86 Patentblatt 86/38**

(84) Benannte Vertragsstaaten:
**AT CH FR GB IT LI SE**

(56) Entgegenhaltungen:
**DE - A - 2 617 335**
**DE - A - 2 641 032**
**FR - A - 2 395 603**

(73) Patentinhaber: **SEMIKRON, GESELLSCHAFT FÜR GLEICHRICHTERBAU UND ELEKTRONIK M.B.H., Sigmundstrasse 200, D-8500 Nürnberg 82 (DE)**

(72) Erfinder: **Schierz, Winfried Ing. grad., Dr. Pfotelstrasse 3, D-8542 Roth (DE)**
Erfinder: **Creutz, Helmut, Ing, grad, Parkstrasse 14, D-8502 Zirndorf (DE)**

**Beschreibung**

Die Erfindung betrifft eine Halbleiterbaueinheit, bei welcher wenigstens zwei Halbleiterbauelemente im Stapel mit ihren jeweils zugeordneten Bauteilen auf einer Kontaktschiene angeordnet sind, bei welcher die Bauteilestapel durch Druck mittels Federkörper mit der Kontaktschiene und über diese elektrisch isoliert und thermisch kontaktiert mit einer metallischen Bodenplatte sowie mit Stromleitungsanschlüssen fest verbunden sind, bei welcher die Bodenplatte zusammen mit einem Rahmen und einem Deckel jeweils aus Isolierstoff ein Gehäuse bildet, und bei welcher das freie Ende der Kontaktschiene durch eine Öffnung des Gehäuses geführt und als Stromanschluss ausgebildet ist.

Eine derartige Halbleiterbaueinheit ist aus der DE-A- 2 617 335 bekannt. Darin ist ein Halbleiterbauelement beschrieben, bei dem zwei Halbleiterelemente jeweils in einer angepassten Aussparung eines Gehäuses angeordnet sind, und bei dem auf den Halbleiterelementen befindliche Kontaktelektroden durch wenigstens eine, zwischen den Aussparungen an einem Steg des Gehäuses befestigte Feder an die Halbleiterelemente angepresst sind. Die Feder kann als Blattfeder ausgebildet sein und ist mittels einer durch den Steg zur Bodenplatte geführten Schraube befestigt.

Weiter ist aus der DE-A- 2 641 032 eine Modul-Baueinheit für in Kompaktbauweise zusammengesetzte Stromrichter bekannt. Zwei Hauptleiterelemente sind jeweils im Stapel mit Kontaktscheiben und Federkörpern in Bohrungen eines z.B. quaderförmigen Gehäuses auf einer die Bodenplatte des Gehäuses bildenden Metallplatte gegen diese elektrisch isoliert fest angeordnet und mit Hilfe der in den Bohrungen gehalterten Federkörper kontaktiert. Die Stromleiterteile der Halbleiterelemente sind in Leiterkanälen des Gehäuses geführt und mit Stromleitungsanschlüssen auf der der Bodenplatte gegenüberliegenden Gehäuseseite verbunden.

Diese bekannten Baueinheiten zeigen verschiedene Nachteile. So ist die Lötkontaktierung der Gleichrichterelemente verfahrenstechnisch aufwendig. Bei Druckkontaktierung derselben mit Einbettung in Isoliermasse macht die starre Einschliessung des für ein elastisches Verhalten im Einsatz vorgesehenen Kontaktsystems den Aufbau störanfällig. Weiter können durch die Verfahrensschritte Löten bzw. Vergiessen in Isoliermasse die elektrischen Eigenschaften beeinträchtigt werden. Ferner führen mechanische Spannungen infolge unterschiedlicher thermischer Ausdehnung von aneinandergrenzenden Materialien häufig zu Qualitätseinbussen. Im Falle der Verschlechterung der Kenngrössen eines von zwei oder mehr Gleichrichterelementen besteht keine Austauschmöglichkeit, so dass die Anordnung bezüglich ihrer Kenngrössen zurückgestuft werden muss oder unbrauchbar ist. Ausserdem trägt keine der bekannten Bauformen dem Bedürfnis der Hersteller Rechnung, die Schritte des Zusammenbaus wiederholt ohne Zwang der Zerstörung halbfertiger Anordnungen zu überwachen und dabei technisch relevante Gesichtspunkte in gewünschter Weise zu berücksichtigen. Auch erlaubt keine der bekannten Ausführungsformen einen Aufbau mit wählbarer elektrischer Orientierung der Halbleiterbauelemente. Schliesslich ist bei Gleichrichteranordnungen mit in Reihe liegenden Stromleitungsanschlüssen wegen deren Beschränkung auf nur eine Anschlussebene ein universeller Einsatz nicht immer möglich.

Der Erfindung liegt die Aufgabe zugrunde, eine Halbleiterbaueinheit zu schaffen, bei welcher die Halbleiterbauelemente in gewünschter elektrischer Polung im Gehäuse einsetzbar, einwandfrei druckkontaktiert und in einer dichten Umhüllung untergebracht sind, welche die elektrischen Eigenschaften der Bauelemente nicht beeinflusst, und welche eine universelle Anwendung sowie in gegenüber gekannten Anordnungen einfacher Weise eine beliebige elektrische Schaltung mehrerer solcher Baueinheiten ermöglicht.

Die Lösung dieser Aufgabe besteht bei der eingangs erwähnten Halbleiterbaueinheit in den kennzeichnenden Merkmalen des Anspruchs 1.

Vorteilhafte Ausgestaltungen der erfindungsgemässen Halbleiterbaueinheit sind in den Ansprüchen 2 bis 18 angegeben.

Anhand der in den Figuren 1 bis 3 dargestellten Ausführungsbeispiele wird der Gegenstand der Erfindung aufgezeigt und erläutert. Figur 1 zeigt teilweise im Querschnitt, teilweise in Seitenansicht und teilweise auch als Explosivdarstellung den Aufbau der Halbleiterbaueinheit. In den Figuren 2a bis c sind teilweise in Draufsicht und teilweise schematisiert vorteilhafte Formgebungen des Gehäuserahmens im Zusammenwirken mit zugeordneten Bauteilen dargestellt. Schliesslich zeigt die Figur 3 im wesentlichen in Seitenansicht den Aufbau von Halbleiterbauelementen für den Gegenstand der Erfindung, für deren Verkapselung zusammen mit den notwendigen Kontaktplatten jeweils eine Aussparung des Gehäuserahmens vorgesehen ist. Für gleiche Teile sind in allen Figuren gleiche Bezeichnungen gewählt.

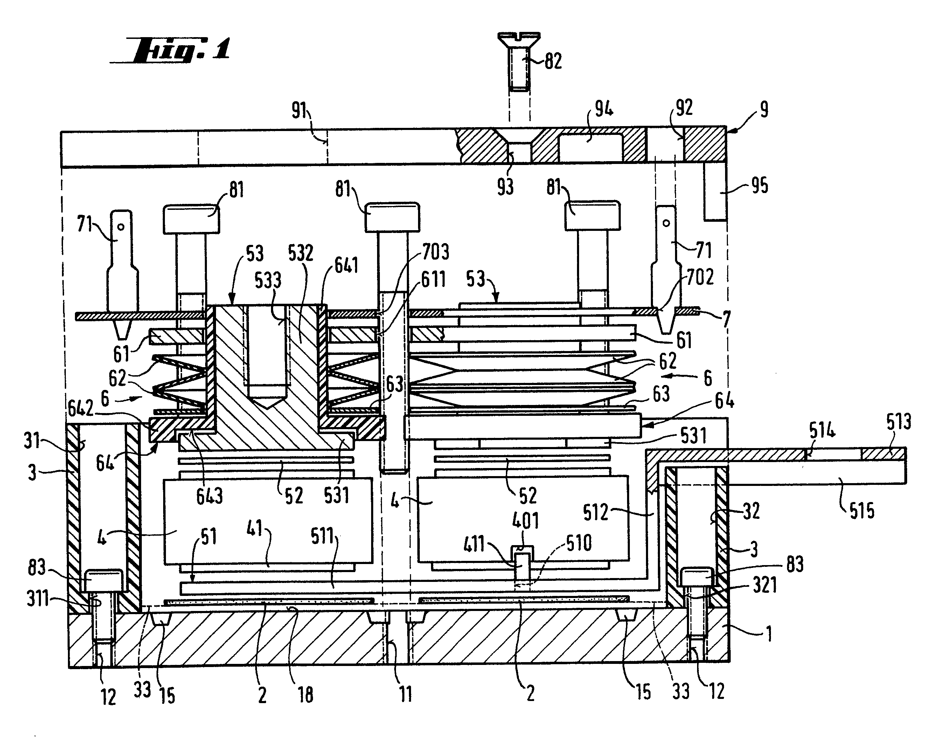

Gemäss Figur 1 dient als Trägerkörper der Halbleiterbaueinheit eine aus Metall hoher Wärmeleitfähigkeit bestehende Bodenplatte 1 mit beispielsweise rechteckförmiger Ausdehnung und mit planen Anlageflächen. Sie weist Gewindelöcher 11 zur Befestigung der Halbleiterbauelemente und ihrer Kontaktbauteile sowie Gewindelöcher 12 zur Befestigung des Gehäuserahmens 3 auf. Die obere Fläche der Bodenplatte 1 enthält in sich geschlossene, grabenförmige Vertiefungen 15. Diese umschliessen jeweils einen planen Flächenabschnitt 18 zur Auflage eines Bauteilestapels. Die Vertiefungen 15 dienen zur Sicherstellung der erforderlichen Kriechstrecke zwischen Stromleitungsbauteilen und der gegen diese elektrisch isolierten Bodenplatte.

Die Flächenabschnitte 18 können auch durch tafelförmige Erhebungen auf der Bodenplatte gebildet sein.

Auf jeden Flächenabschnitt 18 ist jeweils eine Isolierstoffscheibe 2 zur elektrisch isolierten aber thermisch leitenden Anordnung eines Bauteilestapels auf der Bodenplatte 1 aufgebracht. Eine entsprechende Bemessung der Isolierstoffscheibe 2 dient ebenfalls dem notwendigen Isolationsabstand zwischen Bodenplatte 1 und Bauteilestapel. Eine durchgehende, im wesentlichen bandförmige Kontaktschiene 51 verbindet die Isolierstoffscheiben 2. Die Abmessungen der Kontaktschiene 51 richten sich nach den zugeordneten Kontaktflächen der angrenzenden Bauteile und nach der gewünschten Strombelastbarkeit der Baueinheit. Die Kontaktschiene 51 bildet jeweils den einen Anschlussleiter der Halbleiterbauelemente im Gehäuseinneren sowie deren gemeinsamen Stromanschluss. Der Abschnitt 511 der Kontaktschiene 51 verbindet die Halbleiterbauelemente 4; der Abschnitt 512 ist Verbindungsstück zwischen dem gehäuseinneren Anschlussleiter der Halbleiterbauelemente und dem Stromanschluss 513. Dieser weist eine Aussparung 514 zur Befestigung eines Stromleiters auf. Zur Erhöhung der mechanischen Stabilität der Kontaktschiene bei der Befestigung von Stromleitern kann der gehäuseäussere Abschnitt 513 als Längsprofil mit wenigstens einem Profilschenkel 515 ausgebildet sein.

Der Kontaktschienenabschnitt 511 weist zum Beispiel im Zentrum der Auflagefläche des Bauteilestapels zu dessen Justierung eine Durchbohrung 510 zur Aufnahme eines Bolzens 411 auf. Dafür ist der entsprechende Kontaktansatz 41 des Halbleiterbauelements 4 an entsprechender Stelle mit einer Aussparung 401 versehen.

Auf den vorgesehenen, vorzugsweise den Flächenabschnitten 18 der Bodenplatte 1 angepassten Flächenbereichen des Kontaktschienenabschnitts 511 ist jeweils ein Halbleiterbauelement 4 angeordnet. Die Halbleiterbauelemente sind als sogenannte Scheibenzellen dargestellt. Erfindungswesentlich ist die Verwendung von wechselseitig übereinstimmend kontaktierbaren Halbleiterbauelementen, d.h. von solchen mit im wesentlichen beiderseits gleicher Ausbildung ihrer Anschlusselektroden. Das ermöglicht besonders rationell im Zusammenhang mit dem weiteren erfindungswesentlichen Merkmal einer lösbar angeordneten Druckkontaktierung die Austauschbarkeit der Halbleiterbauelemente und liefert jeweils qualitativ optimale Baueinheiten mit gewünschter elektrischer Polung. Vorteilhaft sind daher verkapselte Bauelemente mit scheibenförmigem Gehäuse.

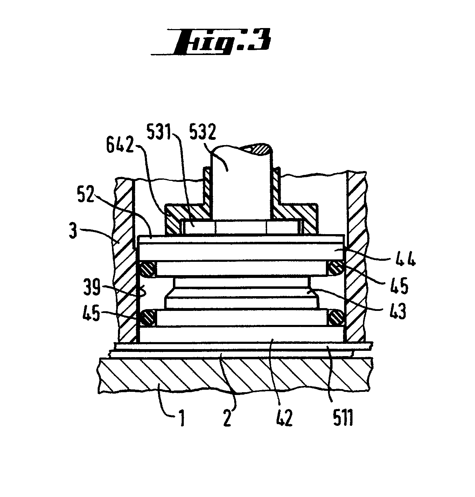

Eine weitere vorteilhafte Bauform ist aus Figur 3 und der zugehörigen Beschreibung zu entnehmen.

Auf jedem Halbleiterbauelement 4 sind jeweils eine Kontaktscheibe 52 und ein stempelförmig ausgebildeter oberer Anschlussleiter 53 konzentrisch angeordnet. Der Anschlussleiter besteht aus einer Anschlussplatte 531 und dem Anschlussschaft 532, welcher ein Gewindesackloch 533 aufweist und gleichzeitig einen gehäuseäusseren Stromanschluss bildet.

Auf dem Anschlussleiter 53 ist über einen Isolierstoffkörper 64 zur elektrisch isolierten Anordnung gegen Stromleitungsbauteile das Druckkontaktsystem 6 aufgebracht. Es besteht aus einer Druckscheibe 63, aus Federkörpern 62 und einer für beide Bauteilestapel gemeinsamen Druckplatte 61. Die Druckplatte 61 weist Durchbohrungen 611 zur Durchführung und Fixierung von Schraubelementen für das Druckkontaktsystem auf. Der Isolierstoffkörper 64 umschliesst mit dem Längsteil 641 und mit dem Flanschteil 642 in angepasster Ausbildung den Anschlussleiter 53 so weit, dass sich die Anschlussplatte 531 in eine Aussparung 643 des Flanschteils erstreckt.

Der Aufbau des Druckkontaktsystems 6 ist an sich bekannt und nicht Teil der Erfindung.

Gemäss der Erfindung sind die Halbleiterbauelemente 4 mit ihren Kontaktbauteilen, also auch mit ihrem jeweils konzentrisch angebrachten und achsial verlaufenden oberen Anschlussleiter 53, mithilfe der gemeinsamen Druckplatte 61 und der Schraubelemente 81, die in die Gewindebohrungen 11 der Bodenplatte 1 geschraubt sind und die Druckplatte 61 auf die Federkörper 62 pressen, durch konzentrischen Druck lösbar sowohl kontaktiert als auch mit der Bodenplatte 1 fest verbunden. Dies ist aus Anordnung, Orientierung und Lage der Gewindebohrungen 11 für das mittlere der dargestellten Schraubelemente 81 zu erkennen.

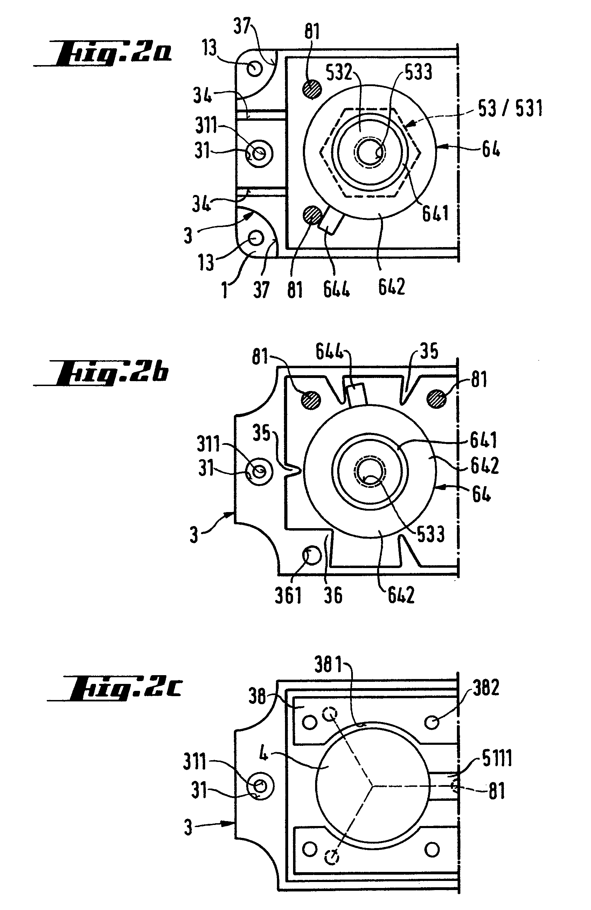

Anzahl und Anordnung der Schraubelemente 81 am Umfang der Bauteilestapel sind dadurch bestimmt, dass auf jeden Stapel durch die Druckplatte ein annähernd gleichmässig konzentrischer Druck wirken soll. Dies ist bereits mit einer Dreipunktverschraubung erzielbar. Jedem Bauteilestapel sind drei gegenseitig im wesentlichen um 120° versetzte Schraubelemente 81 zugeordnet. Da ein im Bereich zwischen den Bauteilestapeln angebrachtes Schraubelement seine Wirkung auf beide Stapel entfaltet, können bei einem Aufbau mit zwei Stapeln ein Schraubelement auf der Gehäuselängsachse zwischen den Bauteilestapeln und je zwei Schraubelemente unter entsprechendem Winkel versetzt zwischen Stapel und Gehäusewand angebracht sein, wie dies in Figur 2c strichliniert angedeutet ist. Bei einer solchen Anordnung weist die Kontaktschiene 51 für die Durchführung eines Schraubelements 81 eine entsprechende Öffnung 5111 auf.

Eine bevorzugte Ausführungsform enthält eine Vierpunktverschraubung jedes Bauteilestapels, wobei zwei Schraubelemente 81 auf der Mittelachse zwischen den Bauteilestapeln und jeweils zwei weitere im Raum zwischen Bauteilestapeln und Gehäuseschmalseite vorgesehen sind, wie dies aus Figur 2c erkennbar ist. Die Bauteilestapel sind in einem Gehäuserahmen 3 aus Isolierstoff, vorteilhaft aus Kunststoff, untergebracht. Der Rahmen 3 ist unmittelbar auf der Bodenplatte 1 befestigt, und sein Umfang ist im wesentlichen dem der Bodenplatte angepasst. Zu diesem Zweck kann der Rahmen zum Beispiel nur als Umfangskörper mit beispielsweise rechteckförmigem Grundriss ausgebildet sein und mit einer Stirnseite auf der Bodenplatte 1 und mit der anderen Stirnseite an einen Deckel 9 angrenzen. Der Gehäuserahmen 3 kann beispielsweise durch Kleben auf der Bodenplatte befestigt sein. Er kann jedoch auch Abschnitte grösserer Wandstärke aufweisen, die abgesetzte Bohrungen 31/311 bzw. 32/321 zur Schraubbefestigung in den Gewindelöchern 12 der Bodenplatte 1 enthalten.

Der Gehäuserahmen 3 kann weiterhin eine an die Bodenplatte angrenzende Anschlussplatte aufweisen, wie dies mit 33 angedeutet ist. Darin sind jeweils Öffnungen für die Bauteilestapel und für die Schraubelemente 81 des Druckkontaktsystems 6 vorgesehen, so dass mit den Bauteilestapeln auch der Gehäuserahmen 3 lösbar auf der Bodenplatte 1 befestigt werden kann.

Die Gehäusehöhe ist so bemessen, dass bei aufgesetztem Deckel 9 lediglich der obere Anschlussleiter 53 jedes Halbleiterbauelements und der gehäuseäussere Abschnitt 513 der Kontaktschiene 51 zugänglich sind.

Sind steuerbare Halbleiterbauelemente vorgesehen, so ist auf die Druckplatte 61 eine Leiterplatte 7 zur Befestigung und Durchführung von Steuerleitungen aufgebracht. Sie weist Öffnungen 702 für die Anbringung von Kontaktfahnen 71 und Aussparungen 703 zur Durchführung der Schraubelemente 81 und der Anschlussleiter 53 (nicht dargestellt) auf.

Der Gehäuserahmen 3 ist mit einem Deckel 9 verschlossen, der mit Öffnungen 91 zur Durchführung der Anschlussleiter 53 und mit Öffnungen 92 zum Durchtritt der Kontaktfahnen 71 versehen ist. Er weist beim dargestellten Ausführungsbeispiel Aussparungen 94 zur gehäuseinneren Aufnahme des Endes der Schraubelemente 81 auf. Der Aufbau der Halbleiterbaueinheit kann jedoch so bemessen sein, dass die Schraubelemente 81 unterhalb des Deckels 9 enden. Der Deckel enthält weiter noch Durchbohrungen 93 für Schrauben 92 zu seiner Befestigung auf der Druckplatte 61.

Die Halbleiterbaueinheit ist somit aufgrund der lösbaren Schraubbefestigung sämtlicher Bauteile jederzeit zerlegbar, so dass ein Austausch von Bauteilen leicht durchzuführen ist.

Eine zwischen Gehäuserahmen 3 und Deckel 9 im Bereich des Kontaktschienenabschnitts 513 verbleibende Öffnung ist z.B. durch einen Ansatz 95 des Deckels 9 verschlossen.

Der gegenseitige Mindestabstand der Bauteilestapel im Gehäuse ist nur durch die Forderung nach ausreichender Spannungsüberschlagsfestigkeit bestimmt.

Bei einer Bauform gemäss Figur 1 verbindet die Kontaktschiene 51 die Halbleiterbauelemente 4. Ist für einen elektrisch getrennten Betrieb der Halbleiterbauelemente jedem derselben jeweils eine Kontaktschiene zugeordnet, so besteht der Aufbau der Baueinheit nach der Erfindung aus zwei gleichen Hälften entsprechend der rechten Hälfte der Darstellung in Figur 1. Dabei können die freien Enden der Kontaktschienen in gleicher oder unterschiedlicher Höhe angebracht sein und gemeinsam an einer Gehäuseseite oder getrennt an unterschiedlichen Gehäuseseiten austreten.

Die gegenüber der Kontaktierungsfläche der Anschlussleiter 53 vorzugsweise beliebig tiefer liegende Verschaltungsebene des Kontaktschienenabschnitts 513 ermöglicht jede gewünschte elektrische Verschaltung der Einzelelemente und/ oder der Baueinheit im Hinblick auf Leitungsführung und Bauteilekombination.

Die Figuren 2a bis c zeigen jeweils für eine Hälfte der Baueinheit Beispiele für die Ausgestaltung des Gehäuserahmens zur lagebestimmten Anordnung der Bauteilestapel. Der Rahmen 3 nach Figur 2a weist Schmalseiten grösserer Dicke mit je einer in ihrem Verlauf abgesetzten Durchbohrung 31/311 zur getrennten Befestigung auf der Bodenplatte 1 auf, wie dies auch in Figur 1 gezeigt ist. Symmetrisch zur Gehäuselängsachse sind je zwei schlitzförmige Vertiefungen 34 zur Aufnahme der Profilschenkel 515 der Kontaktschiene 51 (Figur 1) vorgesehen. Der beispielsweise im wesentlichen einer rechteckförmigen Bodenplatte 1 angepasste Gehäuserahmen 3 enthält an jeder Ecke eine Aussparung 37, die eine Durchbohrung 13 der Bodenplatte 1 zur Befestigung der Baueinheit auf einem Kühlkörper oder auf einem Geräteteil freilegt. Der Schaft 532 des Anschlussleiters 53 mit Gewindesackloch 533 ist von dem Längsteil 641 des Isolierstoffkörpers 64 umschlossen. Dessen Flanschteil 642 weist einen nockenförmigen Ansatz 644 auf. Um nun ein Verdrehen des Anschlussleiters 53 bei Befestigen eines Stromleiters durch Verschrauben zu vermeiden, ist die Aussparung 643 des umschliessenden Flanschteils 642 z.B. vieleckförmig und der Anschlussflansch 531 des Anschlussleiters 53 angepasst eingreifend ausgebildet. Der Flanschteil 642 liegt mit seinem nockenförmigen Ansatz 644 zur Hemmung gegen eine Drehbewegung an einem Schraubelement 81 des Druckkontaktsystems 6 an.

Anstelle einer Justierung in der Drehachse der Bauteilestapel kann dieselbe z.B. durch Justierrippen 35 des Gehäuserahmens 3 erfolgen, wie dies Figur 2b zeigt. Diese Justierrippen können gleichzeitig zur verdrehungshemmenden Fixierung des oberen Anschlussleiters 53 dienen, indem der Ansatz 644 des Isolierstoffkörpers 64, beispielsweise beim Lösen der Anschlussbauteile, an einer solchen Justierrippe 35 anliegt.

Sind nach Figur 2b die Justierrippen 35 verstärkt, z.B. leistenförmig ausgebildet (36) und an entsprechenden Stellen angebracht, so können sie mithilfe einer Durchbohrung 361 gleichzeitig zur Führung eines Schraubelements 81 und damit zur Fixierung des Gehäuserahmens 3 in Zusammenhang mit der Druckkontaktierung dienen. Dabei können die Durchbohrungen 31/311 entfallen.

Gemäss Figur 2c sind zur Justierung der Bauteilestapel auch Distanzstücke 38 zwischen Stapel und Gehäusewand geeignet. Sie sind im wesentlichen leistenförmig ausgebildet und weisen eine im Bereich jedes Halbleiterbauelements 4 oder jedes Bauteilestapels angepasste Einbuchtung 381 für dessen lagebestimmte Aufnahme sowie entsprechend angeordnete Durchbohrungen 382 zur Führung der Schraubelemente 81 auf.

Figur 3 zeigt ein anstelle einer Scheibenzelle innerhalb des Gehäuserahmens 3 gebildetes, wechselseitig übereinstimmend kontaktierbares Halbleiterbauelement. Dazu ist innerhalb des Rahmens für jedes Halbleiterbauelement eine Aussparung 39 vorgesehen. Diese kann in einem massiven Rahmenkörper erzeugt oder mithilfe von rippenförmigen Ansätzen zwischen den Rahmenwänden gebildet sein und ist zum Einbringen und zur geführten Anordnung der beiden am Halbleiterkörper 43 anliegenden Kontaktplatten 42, 44 entsprechend bemessen. Der in der Aussparung 39 zwischen den Kontaktplatten 42, 44 eingeschlossene Halbleiterkörper ist mithilfe von Dichtungsringen 45, die jeweils zwischen der stufenförmig abgesetzten Randzone jeder Kontaktplatte und der gehäuseinneren Wandung der Aussparung angebracht sind, dicht verkapselt. Auf dem derart gebildeten Halbleiterbauelement sind Kontaktscheibe 52, Anschlussleiter 53 und Isolierstoffkörper 64 aufgebracht.

Sind die Aussparungen 39 in einem massiven Gehäusekörper ausgebildet, so enthält dieser vorzugsweise weiter Durchbohrungen für die Schraubelemente 81, bedarfsweise weiter solche für die getrennte Befestigung des Gehäuserahmens 3 und auch jeweils eine Aussparung für den Eingriff des nockenförmigen Ansatzes 644 zur verdrehungshemmenden Anordnung der Anschlussleiter 53.

Die Vorteile des Gegenstandes der Erfindung bestehen in einem wirtschaftlich optimalen Zusammenbau ohne besondere Behandlung von Bauteilen, in einem allen Schaltungswünschen genügenden Aufbau, in der Sicherstellung vorbestimmter Kenngrössen für die Bauelemente und für die Baueinheit, in der Möglichkeit einer beliebigen, zerstörungsfreien Kontrolle des Zusammenbaus und darin, dass die einfache Anordnung der Halbleiterbauelemente in beliebiger elektrischer Polung und deren nachträgliche Änderung möglich sind.

**Patentansprüche**

1. Halbleiterbaueinheit, bei welcher wenigstens zwei Halbleiterbauelemente (4) im Stapel mit ihren jeweils zugeordneten Bauteilen auf einer Kontaktschiene (51) angeordnet sind, bei welcher die Bauteilestapel durch Druck mittels Federkörper (62) mit der Kontaktschiene (51) und über diese elektrisch isoliert und thermisch kontaktiert mit einer metallischen Bodenplatte (1) sowie mit Stromleitungsanschlüssen fest verbunden sind, bei welcher die Bodenplatte (1) zusammen mit einem Rahmen (3) und einem Deckel (9) jeweils aus Isolierstoff ein Gehäuse bildet, und bei welcher das freie Ende der Kontaktschiene (51) durch eine Öffnung des Gehäuses geführt und als Stromanschluss (513) ausgebildet ist, dadurch gekennzeichnet, dass jeder Bauteilestapel über dem Halbleiterbauelement (4) einen koaxial verlaufenden, verdrehungssicher angeordneten, oberen Anschlussleiter (53) aufweist, der an seinem durch eine Öffnung (91) des Gehäusedeckels (9) geführten Schaft (532) als gehäuseäusserer Stromanschluss ausgebildet ist, dass wechselseitig übereinstimmend kontaktierbare Halbleiterbauelemente (4) vorgesehen sind, dass jedes Halbleiterbauelement (4) mit Hilfe eines Druckkontaktsystems aus einer für beide Bauteilestapel gemeinsamen Druckplatte (61) sowie aus Federkörper (62) und Befestigungsmitteln (81) sowohl mit seinen Kontaktbauteilen als auch mit der Bodenplatte (1) lösbar fest verbunden ist, und dass der Gehäuserahmen (3) lösbar auf der Bodenplatte (1) und der Gehäusedeckel (9) lösbar auf der Druckplatte (61) befestigt sind.

2. Halbleiterbaueinheit nach Anspruch 1, dadurch gekennzeichnet, dass Halbleiterbauelemente mit scheibenförmiger Verkapselung vorgesehen sind.

3. Halbleiterbaueinheit nach Anspruch 1, dadurch gekennzeichnet, dass Halbleiterbauelemente vorgesehen sind, bei denen die am Halbleiterkörper (43) anliegenden Kontaktplatten (42, 44) in einer Aussparung (39) im Rahmen (3) des aus metallischer Bodenplatte (1) sowie aus Rahmen (3) und Deckel (9) aus Isolierstoff bestehenden Gehäuse geführt angeordnet sind und in der Aussparung mithilfe von Dichtungsringen (45) einen dichten Verschluss für Halbleiterkörper (43) bilden.

4. Halbleiterbaueinheit nach Anspruch 1, dadurch gekennzeichnet, dass die Bauteilestapel nebeneinander auf einer gemeinsamen Kontaktschiene (51) angeordnet und über diese elektrisch verbunden sind.

5. Halbleiterbaueinheit nach Anspruch 1, dadurch gekennzeichnet, dass jedem Bauteilestapel eine Kontaktschiene zugeordnet ist.

6. Halbleiterbaueinheit nach Anspruch 1, dadurch gekennzeichnet, dass das Gehäuse rechteckförmigen Grundriss aufweist, dass das freie Ende der Kontaktschiene (513) jeweils an einer Gehäuseschmalseite herausgeführt ist, und dass die Stromanschlüsse in einer Reihe liegen.

7. Halbleiterbaueinheit nach Anspruch 1, dadurch gekennzeichnet, dass das Gehäuse rechteckförmigen Grundriss aufweist, und dass das freie Ende (513) der Kontaktschiene (51) jeweils an einer Gehäuselangseite herausgeführt ist.

8. Halbleiterbaueinheit nach Anspruch 1, dadurch gekennzeichnet, dass das Gehäuse rechteckförmigen Grundriss aufweist, und dass die freien Enden der Kontaktschienen an einer gemeinsamen Gehäuselangseite herausgeführt sind.

9. Halbleiterbaueinheit nach Anspruch 1, dadurch gekennzeichnet, dass jeweils der im Bauteilestapel befindliche obere Anschlussleiter (53) jedes Halbleiterbauelements (4) und der den Anschlussleiter gegenüber Bauteilen des Kontaktdrucksystems elektrisch isolierende Isolierstoffkörper (64) an ihren aneinandergrenzenden Abschnitten (531, 642) gegenseitig verdrehungssicher ausgebildet sind, und dass der Isolierstoffkörper zusätzlich einen Ansatz (644) aufweist, der an einem Befestigungselement (81) oder an einem Fortsatz (35) des Gehäuserahmens (3) verdrehungshemmend anliegt.

10. Halbleiterbaueinheit nach Anspruch 9, dadurch gekennzeichnet, dass die aneinandergrenzenden Abschnitte (531, 642) übereinstimmend vieleckförmig und gegenseitig ineinandergreifend ausgebildet und angeordnet sind.

11. Halbleiterbaueinheit nach Anspruch 1, dadurch gekennzeichnet, dass der Gehäuserahmen (3) an der der Bodenplatte (1) zugewandten Kante eine Abschlussplatte (33) mit jeweiligen Öffnungen zur Aufnahme der Bauteilestapel und zur Durchführung der Befestigungselemente (81) aufweist und mittels der letzteren gemeinsam mit den Bauteilestapeln auf der Bodenplatte (1) lösbar befestigt ist.

12. Halbleiterbaueinheit nach einem der vorhergehenden Ansprüche, dadurch gekennzeichnet, dass der Gehäuserahmen (3) Abschnitte mit grösserer Wandstärke aufweist, die wenigstens eine Durchbohrung (31/311; 32/321) zur getrennten Befestigung des Rahmens auf der Bodenplatte (1) enthalten.

13. Halbleiterbaueinheit nach einem der vorhergehenden Ansprüche, dadurch gekennzeichnet, dass der Gehäuserahmen (3) Abschnitte (36) mit grösserer Wandstärke aufweist, die angepasste Durchbohrungen (361) zur Führung der Schraubelemente (81) enthalten.

14. Halbleiterbaueinheit nach einem der vorhergehenden Ansprüche, dadurch gekennzeichnet, dass der Gehäuserahmen (3) aus einem massiven Körper gebildet ist und Aussparungen zur Aufnahme der Bauteilestapel und der Kontaktschiene (51) sowie Durchbohrungen zur Führung der Schraubelemente (81) aufweist.

15. Halbleiterbaueinheit nach einem der vorhergehenden Ansprüche, dadurch gekennzeichnet, dass der Gehäuserahmen (3) rippenförmige Ausbildungen (35) zur lageorientierten Anordnung der Bauteilestapel aufweist.

16. Halbleiterbaueinheit nach einem der vorhergehenden Ansprüche, dadurch gekennzeichnet, dass zwischen Gehäuserahmen (3) und Bauteilestapel im wesentlichen leistenförmige Distanzstücke (38) mit angepassten Aussparungen (381) zur vorbestimmten räumlichen Anordnung der Bauteilestapel vorgesehen sind, und dass die Distanzstücke Durchbohrungen (382) zur Führung der Befestigungselemente (81) aufweisen.

17. Halbleiterbaueinheit nach Anspruch 1, dadurch gekennzeichnet, dass steuerbare Halbleiterbauelemente vorgesehen sind, und dass die Steuerleitungen zu einer Leiterplatte (7) zwischen Druckplatte (61) und Gehäusedeckel (9) geführt sind.

18. Halbleiterbaueinheit nach einem der vorhergehenden Ansprüche, dadurch gekennzeichnet, dass zwischen jeweils zu verbindenden Gehäuseteilen Dichtungsmittel vorgesehen sind.

## Claims

1. Semiconductor unit in which at least two semiconductor elements (4) are arranged in the stack with their respective associated components on a contact rail (51), the component stacks are fixedly connected by pressure by means of spring bodies (62) to the contact rail (51) and via the latter electrically insulated and thermally contacted to a metallic bottom plate (1) and to current lead terminals, the bottom plate (1) forming together with a frame (3) and a cover (9) in each case a housing of insulating material, and the free end of the contact rail (51) being led through an opening of the housing and formed as current terminal (513), characterized in

that each component stack comprises above the semiconductor element (4) a coaxially extending non-rotatable upper terminal conductor (53) which is formed at its shank (532) led through an opening (91) of the housing cover (9) as outside terminal connection, that alternately identical contactable semiconductor elements (4) are provided,

that each semiconductor element (4) is detachably firmly connected with the aid of a pressure contact system comprising a pressure plate (61) common to both component stacks as well as spring bodies (62) and securing means (81) both to its contact components and to the bottom plate (1) and

that the housing frame (3) is secured detachably to the bottom plate (1) and the housing (9) detachably to the pressure plate (61).

2. Semiconductor unit according to claim 1, characterized in that semiconductor elements with slice-shaped encapsulations are provided.

3. Semiconductor unit according to claim 1, characterized in that semiconductor elements are provided in which the contact plates (42, 44) bearing on the semiconductor body (43) are disposed in a recess (39) in the frame (3) of the housing consisting of metal bottom plate (1) and of frame (3) and cover (9) of insulating material and form in the recess with the aid of sealing rings (45) a sealed closure for the semiconductor body (43).

4. Semiconductor unit according to claim 1, characterized in that the component stacks are arranged adjacent each other on a common contact rail (51) and connected electrically via said rail.

5. Semiconductor unit according to claim 1, characterized in that a contact rail is associated with each component stack.

6. Semiconductor unit according to claim 1, characterized in that the housing has a rectangular plan view, that the free end of the contact rail (513) is led out at a housing narrow side and that the current terminals lie in a row.

7. Semiconductor unit according to claim 1, characterized in that the housing has a rectangular plan view and that the free end (513) of the contact rail (51) is led out at a housing longitudinal side.

8. Semiconductor unit according to claim 1, characterized in that the housing has a rectangular plan view and that the free ends of the contact rails are led out at a common housing longitudinal side.

9. Semiconductor unit according to claim 1, characterized in that the terminal conductor (53) of each semiconductor element (4) which is at the top of the component stack and the insulating body (64) electrically insulating the terminal conductor with respect to the components of the contact pressure system are formed mutually fixed in rotation at their adjoining portions (531, 642) and that the insulating body additionally comprises an extention (644) which bears on a securing element (81) or a continuation (35) of the housing frame (3) to inhibit rotation.

10. Semiconductor unit according to claim 9, characterized in that the adjoining portions (531, 642) are made and arranged congruently polygonally and mutually interengaging.

11. Semiconductor unit according to claim 1, characterized in that the housing frame (3) comprises at the edge facing the bottom plate (1) a closure plate (33) with respective openings for receiving the component stacks and for passage of the securing elements (81) and by means of the latter is detachably secured jointly with the component stacks on the bottom plate (1).

12. Semiconductor unit according to any one of the preceding claims, characterized in that the housing frame (3) comprises portions of greater wall thickness which contain at least one throughbore (31/311; 32/321) for separate securing of the frame to the bottom plate (1).

13. Semiconductor unit according to any one of the preceding claims, characterized in that the housing frame (3) comprises portions (36) with greater wall thickness including adapted throughbores (361) for guiding the screw elements (81).

14. Semiconductor unit according to any one of the preceding claims, characterized in that the housing frame (3) is formed from a solid body and comprises recesses for receiving the component stacks and the contact rail (51) and throughbores for guiding the screw elements (81).

15. Semiconductor unit according to any one of the preceding claims, characterized in that the housing frame (3) has rib-like formations (35) for position-oriented arrangement of the component stacks.

16. Semiconductor unit according to any one of the preceding claims, characterized in that between the housing frame (3) and component stacks substantially strip-shaped spacers (38) are provided with adapted recesses (381) for predetermined spatial arrangement of the component stacks and that the spacers have throughbores (382) for guiding the securing elements (81).

17. Semiconductor unit according to claim 1, characterized in that controllable semiconductor elements are provided and that the control lines are led to a printed circuit board (7) between the pressure plate (61) and housing cover (9).

18. Semiconductor unit according to any one of the preceding claims, characterized in that between the housing parts to be connected sealing means are provided.

**Revendications**

1. Unité de semiconducteurs dont:

au moins deux éléments constitutifs semiconducteurs (4) sont disposés chacun, avec les éléments associés sur eux, sur un rail de contact (51),

la pile d'éléments gerbés est fixée, grâce à la pression d'un ressort (62) sur le rail de contact (51) et assemblée par l'intermédiaire de ce dernier, en étant isolée électriquement mais en contact thermique, avec une plaque de fond métallique (1) et des raccords électriques,

la plaque de fond (1) constitue, avec un châssis (3) et un couvercle (9) en matériau isolant, un boîtier,

l'extrémité libre du rail de contact (51) qui traverse une ouverture dans le boîtier, constitue un raccord électrique (513), caractérisée en ce que:

chaque empilement d'éléments sur l'élément constitutif semiconducteur (4) comporte un conducteur de raccordement (53) disposé en haut de la pile, coaxial à celle-ci, rigide en torsion, dont la tige (532) traversant une ouverture (91) dans le couvercle (9), constitue un raccord électrique à l'extérieur du boîtier,

les éléments constitutifs semiconducteurs (4) peuvent être mis en contact électrique à l'extérieur du boîtier,

les éléments constitutifs semiconducteurs (4) peuvent être mis en contact en concordant réciproquement,

chaque élément constitutif semiconducteur (4) est assemblé, en étant amovible, tant avec ses éléments de contact qu'avec la plaque de fond, grâce à un dispositif de contact par pression, composé d'une plaque de pression (61) commune aux deux piles d'éléments sur les éléments constitutifs semiconducteurs (4), d'un ressort (62) et de moyens de fixation (81),

le châssis (3) est fixé en étant amovible sur la plaque de fond (1), le couvercle de la même manière sur la plaque de compression (61).

2. Unité de semiconducteurs selon la revendication 1 caractérisée par des éléments constitutifs semiconducteurs pourvus d'un moyen de fermeture en forme de disque.

3. Unité de semiconducteurs selon la revendication 1 caractérisée par des éléments constitutifs semiconducteurs dont les plaques de contact (42, 44) s'appuyent sur le corps semiconducteurs (43) sont disposées dans un évidement (39), ménagé dans le châssis (3) du boîtier, composé d'une plaque de fond (1) métallique ainsi que d'un châssis (3) et d'un couvercle (9) en matériau isolant, et forment pour le corps semiconducteur (43) dans ledit évidement une enveloppe étanche, à l'aide d'anneaux d'étanchéité (45).

4. Unité de semiconducteurs selon la revendication 1 caractérisée en ce que les piles d'éléments constitutifs sont disposées, l'une à côté de l'autre, sur un rail de contact commun (51) par lequel elles sont reliées électriquement.

5. Unité de semiconducteurs selon la revendication 1 caractérisée en ce que chaque pile d'éléments constitutifs coopère avec un rail de contact distinct.

6. Unité de semiconducteurs selon la revendication 1 caractérisée en ce que le boîtier présente une base rectangulaire, que l'extrémité libre (513) du rail de contact sort du boîtier sur un côté étroit de celui-ci et que les raccords électriques sont disposés en ligne.

7. Unité de semiconducteurs selon la revendication 1 caractérisée en ce que le boîtier présente une base rectangulaire et que l'extrémité libre (513) du rail de contact sort du boîtier sur un côté large de celui-ci.

8. Unité de semiconducteurs selon la revendication 1 caractérisée en ce que le boîtier présente une base rectangulaire et que des rails de contact sortent du boîtier sur un même côté large de celui-ci.

9. Unité de semiconducteurs selon la revendication 1 caractérisée en ce que les parties (531) et (642), au contact l'une de l'autre, du conducteur de raccordement (53) disposé en haut de l'empilement d'éléments sur chaque élément constitutif semiconducteur (4), d'une part, et, du corps en matériau isolant (64) qui isole le conducteur de raccordement (53) des éléments composant le dispositif de contact par pression, d'autre part, sont rigides en torsion l'une par rapport à l'autre, et, en ce que le corps en matériau isolant comporte une saillie (644) qui s'appuie, en empêchant une torsion, sur un élément de fixation (81) ou une saillie (35) du châssis (3) du boîtier.

10. Unité de semiconducteurs selon la revendication 9 caractérisée en ce que les parties (531) et (642) du conducteur de raccordement (53), respectivement du corps en matériau isolant (64), sont de forme polygonale correspondante et s'engageant l'une dans l'autre.

11. Unité de semiconducteurs selon la revendication 1 caractérisée en ce que le châssis (3) comporte sur son chant orienté vers la plaque de fond (1) une plaque de fermeture (33) munie des évidements correspondants destinés à la réception de la pile d'éléments constitutifs et au passage des éléments de fixation (81) par lesquels ledit châssis et la pile d'éléments constitutifs sont fixés, en étant amovibles, sur la plaque de fond (1).

12. Unité de semiconducteurs selon l'une des revendications 1 à 11 caractérisée en ce que le châssis (3) du boîtier comporte des parties de paroi de plus grande épaisseur qui sont pourvues d'au moins un alésage (31/311), (32/321) destinés à la fixation dudit châssis sur la plaque de fond (1).

13. Unité de semiconducteurs selon l'une des revendications 1 à 12 caractérisée en ce que le châssis (3) du boîtier comporte des parties (36) de paroi de plus grande épaisseur qui sont pourvues d'alésages (361) adaptés au guidage des éléments de fixation (81) à vis.

14. Unité de semiconducteurs selon l'une des revendications 1 à 13 caractérisée en ce que le châssis (3) du boîtier est constitué d'un corps massif comportant des évidements destinés à la réception des piles d'éléments constitutifs et du rail de contact (51) ainsi que des alésages destinés au guidage des éléments de fixation (81) à vis.

15. Unité de semiconducteurs selon l'une des revendications 1 à 14 caractérisée en ce que le châssis (3) du boîtier comporte des saillies en forme de nervures (35) destinées à l'orientation de la position des piles d'éléments constitutifs empilés.

16. Unité de semiconducteurs selon l'une des revendications 1 à 15 caractérisée par des pièces d'écartement (38) sensiblement en forme de listel, disposées entre le châssis (3) du boîtier et la pile d'éléments constitutifs empilés, munies d'évidements (381) adaptés à une orientation de la position de ladite pile d'éléments constitutifs et comportant des alésages (382) pour le guidage des éléments de fixation (81) à vis.

17. Unité de semiconducteurs selon la revendication 1 caractérisée par des éléments constitutifs semiconducteurs à commandes et par des alimentations reliées à une plaque conductrice (7) disposée entre la plaque de compression (61) et le couvercle (9) du boîtier.

18. Unité de semiconducteurs selon l'une des revendications 1 à 17 caractérisée par des moyens d'étanchéité prévus entre des parties de boîtier devant être assemblées.

**Fig. 1**

**Fig. 2a**

**Fig. 2b**

**Fig. 2c**

# Fig.3